# EUROPÄISCHE PATENTSCHRIFT

(11) **EP 0 443 115 B1**
(45) Veröffentlichungstag und Bekanntmachung des Hinweises auf die Patenterteilung: **30.08.1995**
(21) Anmeldenummer: 90122761.1
(22) Anmeldetag: 28.11.1990
(51) Int. Cl.: H03H 17/02

(54) **Wellendigitalfilter bestehend aus Speichern und n-Tor-Adaptoren**
Wave digital filter composed of memories and n-port adaptors
Filtre numérique d'ondes composé de mémoires et d'adaptateurs n-portes

(30) Priorität: 20.02.1990 DE 4005320
(43) Veröffentlichungstag der Anmeldung: 28.08.1991
(73) Patentinhaber: SIEMENS AKTIENGESELLSCHAFT, 80333 München (DE)
(72) Erfinder: Schwartz, Hans-Dieter, W-8000 München 71 (DE)

(56) Entgegenhaltungen:
- FR-A- 2 336 835
- IEEE TRANSACTIONS ON CIRCUITS AND SYSTEMS, Band CAS-22, Nr. 3, März 1975,Seiten 239-246, New York, US; A. FETTWEIS et al.: "Suppression of parasiticoscillations in wave digital filters"

## Beschreibung

Die Erfindung betrifft ein Wellendigitalfilter (WDF) nach dem Oberbegriff des Patentanspruches 1.

Digitale Filter und Entzerrer verarbeiten zeitdiskrete Abtastsignale digital; ihre prinzipielle Arbeitsweise wird durch ihre Struktur (Signalgraph) und ihre Übertragungsfunktion H(z) (Verhältnis Y/X der z-Transformierten von Ausgangs- zu Eingangssignal) beschrieben. Die wichtigsten bekannten Strukturen rekursiver Digitalfilter/-entzerrer sind Direktformen höheren Grades, Kaskadenschaltungen von Teilstrukturen niedrigen Grades, Parallelschaltungen von Teilstrukturen niedrigen Grades, Wellendigitalfilter-Abzweigstrukturen, Wellendigitalfilter-Brückenstrukturen, Wellendigitalfilter-Allpaßstrukturen.

Am Ende der Beschreibung wird ein Literaturverzeichnis angegeben, in dem über Wellendigitalfilter, deren Theorie und Praxis und deren Pseudopassivität und das eventuelle Auftreten parasitärer Schwingungen in solchen Wellendigitalfiltern berichtet wird.

Bekannte Probleme bei der Implementierung rekursiver Digitalfilter/-entzerrer sind:
A. Infolge der hardware-bedingten endlichen Rechengenauigkeit können granulare Grenzzyklen und/oder grobe Überlaufschwingungen auch bei Nullsignal am Eingang auf Dauer auftreten. Dieses Problem tritt bei Strukturen auf, die als Direktformen höheren Grades, oder Kaskaden- oder Parallelschaltung von Teilstrukturen niedrigen Grades ausgebildet sind.
B. Nicht jede hinsichtlich Grad und Werten beliebige zulässige gebrochen rationale Übertragungsfunktion ist auf einheitliche Weise realisierbar. Dieses Problem tritt mit wachsender Schärfe bei den vorgenannten Wellendigitalfilter-Strukturen auf.
C. Die die Leistungsfähigkeit der Hardware einschränkende Rechentiefe ist mit wachsendem Grad der Übertragungsfunktion stark zunehmend bei den Strukturen mit Direkt-formen höheren Grades oder mit Wellendigitalfilter-Allpaßstrukturen nach Literaturstelle [5].

Keine bekannte Struktur ist also ohne eines der genannten Probleme.

Zur Lösung der anstehenden Probleme ist man bislang folgendermaßen vorgegangen.

### Problem A:

Passend zur vorliegenden konkreten Übertragungsfunktion werden die Auswirkungen der endlichen Rechengenauigkeit individuell untersucht;
entweder (sofern möglich) werden die Auswirkungen durch dem Einzelfall angepaßte Gegenmaßnahmen gemildert oder akzeptiert,
oder man kann zurückgreifen auf Gegenmaßnahmen, die für jeweils kleine Klassen von Übertragungsfunktionen bekannt sind,
oder man verwendet Wellendigitalfilter-Strukturen die infolge der Pseudopassivität der verwendeten Adaptor-Bausteine das Problem nicht besitzen. [2, 4]

### Problem B:

Man bestimmt eine geeignete Näherung der vorgesehenen Übertragungsfunktion
oder kann auf die vorerwähnten Direktformen bzw. Kaskaden oder Parallelschaltungs-Strukturen ausweichen.

### Problem C:

Hierfür sind keine Lösungsvorschläge bekannt.

Der Erfindung liegt die Aufgabe zugrunde, Wellendigitalfilterstrukturen anzugeben, bei denen die Übertragungsfunktion (Y/X) beliebig vorgebbar ist. Es lassen sich auch sogenannte kanonische Formen angeben, also Formen, bei denen die WDF-Strukturen hinsichtlich Speicherzahl und Multiplizierer kanonisch sind, d.h. die Anzahl der freien Parameter in der Übertragungsfunktion entspricht den Elementen der Schaltung.

Diese Aufgabe wird gemäß der Erfindung nach den kennzeichnenden Merkmalen des Patentanspruches 1 gelöst.

Vorteilhafte Ausführungsformen sind in den Unteransprüchen angegeben.

Anhand von Ausführungsbeispielen wird nachstehend die Erfindung noch näher erläutert.

Es zeigen in der Zeichnung
- Fig. 1a): einen Wellendigitalfilter-Allpaß Grad 1 (fett) ergänzt zum Grad-1-Resonatorkern,
- 1b): einen Wellendigitalfilter-Allpaß Grad 2 (fett) ergänzt zum Grad-2-Resonatorkern,
- 1c): eine innere Adaptor-Struktur mit Kernfaktor K als Beispiel,
- Fig. 2: einen Wellendigitalfilter-Allpaß Grad g,
- Fig. 3: eine vollständige Aus- und Einkopplung an den Grad-g-Resonatorkern,
- Fig. 4: ein Ausführungsbeispiel für einen einstellbaren Dämpfungsentzerrer mit der Übertragungsfunktion vom Grad 2, dabei kann mit dem Baustein K₁ die Bandbreite, mit dem Baustein K₂ die Resonanzfrequenz und mit dem Baustein A die Amplitude beeinflußt werden,
- Fig. 5: die Dämpfung (a-a₀) in Abhängigkeit von einer normierten Frequenz (f/fₐ) für den Entzerrer nach Figur 4, die Symbole A, K₁ und K₂ lassen deren Wirkung in der Dämpfungskurve erkennen,
- Fig. 6: ein Ausführungsbeispiel für eine Schaltung, die einen sogenannten Auskoppeltyp darstellt, die Übertragungsfunktion hat den Grad 2, die (Teil-) Filterschaltung mit strukturbedingter Sperrstelle auf dem z-Einheitskreis ist realisierbar, Teile des ersten Adaptors können entfallen,
- Fig. 7: Beispiele einstellbarer Dämpfungsgänge für eine Schaltung nach Figur 6, aufgetragen ist die Dämpfung a in Abhängigkeit von einer normierten Frequenz f/fₐ und der Einfluß des Multiplikationsfaktors Aₖ/Aₑ ist an der eingezeichneten Pfeilrichtung erkennbar,
- Fig. 8: ein Ausführungsbeispiel für einen sogenannten Einkoppeltyp, dabei hat die Übertragungsfunktion den Grad 2 (wie in Figur 6), es ergibt sich eine (Teil)-Filterschaltung mit strukturbedingter Sperrstelle auf dem z-Einheitskreis und Teile des ersten Adaptors können entfallen.

Zu den einzelnen Schaltungen sei noch folgendes ausgeführt.

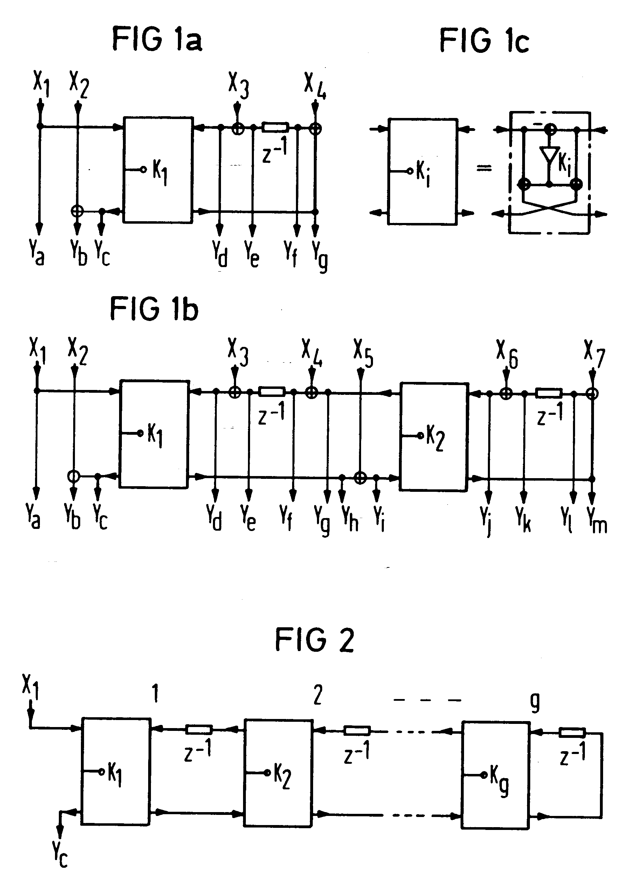

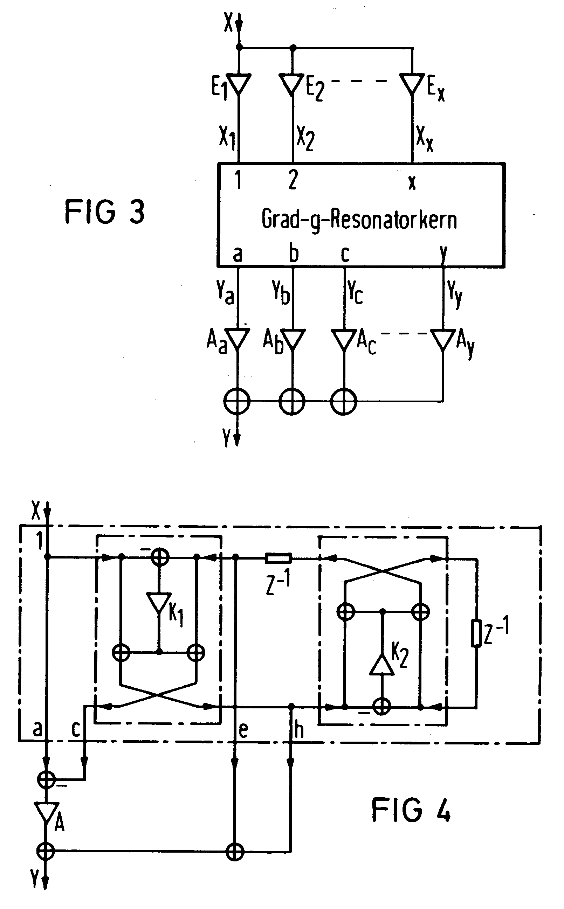

Gemäß den der Erfindung zugrundeliegenden Überlegungen entsteht also ein Wellendigital-Filter/Entzerrer mit beliebig vorgegebener Übertragungsfunktion Y/X dadurch, daß von einer zum Grad g und zu den Nennernullstellen der Übertragungsfunktion passenden Wellendigitalfilter-Struktur, vorzugsweise von einer Wellendigitalfilter-Allpaßstruktur, die bekanntlich eine reguläre Struktur aus Zweitor-Adaptoren und Speichern besitzt, (vgl. Figur 1 und Figur 2) ausgegangen wird. Das Filter-/Entzerrer-Eingangssignal X wird, über Multiplizierer E₁ ... Eₓ individuell gewichtet, an allen Adaptor-Ein- und Ausgängen mit Summierern eingekoppelt und das Filter-/Entzerrer-Ausgangssignal Y wird durch Summierung der über weitere Multiplizierer Aₐ ... A_{y} gewichteten, an allen Adaptor- und Speicher-Ein- und Ausgängen ausgekoppelten Signale gebildet, siehe Fig. 3 in Verbindung z.B. mit Fig. 1b.

In Figur 1a ist zu erkennen ein Wellendigitalfilter-Allpaß vom Grad 1, der fett eingezeichnet ist, und der ergänzt ist zum Grad-1-Resonatorkern mit 4 Ein- und 7 Auskoppel-Schaltungspunkten. Die Einkoppelschaltungspunkte sind mit X₁ bis X₄, die Auskoppelschaltungspunkte mit Yₐ bis Y_{g} bezeichnet. Die Figur 1b zeigt einen Wellendigitalfilter-Allpaß vom Grad 2, in der Zeichnung fett eingetragen, der ergänzt ist zum Grad-2-Resonatorkern mit 7 Ein- und 13 Auskoppel-Schaltungspunkten. Die Einkoppelschaltungspunkte sind hier mit X₁ bis X₇, die Auskoppelschaltungspunkte mit Yₐ bis Yₘ bezeichnet. Die Figur 1c zeigt einen Adaptor mit einer beispielhaften innerern Struktur die wiederum aus einem Multiplizierer Kᵢ und Summierern (+) besteht und die hier als Baustein von Wellendigitalfilter (WDF)-Allpässen wirkt.

Die Figur 2 zeigt einen Wellendigitalfilter-Allpaß vom Grad g der aus g Adaptoren mit je einem Multiplizierer Kᵢ (i = 1 ... g) betsteht. Dazu gehören g Speicher, die mit z-¹ bezeichnet sind. Dargestellt ist das Eingangssignal X₁ und das Ausgangssignal Y_{c}.

Figur 3 zeigt eine vollständige Ein- und Auskopplung am Grad-g-Resonatorkern. Die Einkopplung erfolgt über Einkoppelmultiplizierer E₁ bis Eₓ und die Auskopplung erfolgt über Auskoppel-Multiplizierer Aₐ bis A_{y}. Entsprechend den bisherigen Ausführungen ist das Eingangssignal mit X und das Ausgangssignal mit Y bezeichnet. In der Schaltung von Figur 3 ist noch zu erkennen, daß das Eingangssignal X über die Multiplizierer E₁, E₂ ... Eₓ in die Eingangssignale X₁, X₂ ... Xₓ aufgespalten wird. Diese Eingangssignale gelangen an den Punkten 1, 2, ... x in den Grad-g-Resonatorkern. An den Punkten a, b, c, ... y erscheinen die Ausgangssignale Yₐ, Y_{b}, Y_{c}, ... Y_{y}. Diese Ausgangssignale werden über die Multiplizierer Aₐ, A_{b}, A_{c} ... A_{y} je für sich geführt. Die Ausgangssignale der Multiplizierer Aₐ bis A_{y} werden über Summierer (+) zusammengefaßt und erscheinen als Ausgangssignal Y des Grad-g-Resonatorkerns.

Die Figur 4 zeigt ein Ausführungsbeispiel eines Auskoppeltyps, d.h. die Einkopplung des Eingangssignals X mit der Gewichtung 1 wird nur an einem Schaltungspunkt 1 vorgenommen. Das Ausgangsignal Y wird durch Summation der an den zwei Schaltungspunkten e und h ausgekoppelten Signale mit der mit dem Multiplizierer A gewichteten Differenz der an zwei weiteren Schaltungspunkten, nämlich a und c ausgekoppelten Signale, gewonnen. Mit dem Baustein K₁ kann die Bandbreite, mit dem Baustein K₂ kann die Resonanzfrequenz und mit dem Baustein A kann die Amplitude beeinflußt werden. Es handelt sich im Beispiel also um einen kanonischen Dämpfungsentzerrer, der die drei Parameter K₁, K₂ und A hat.

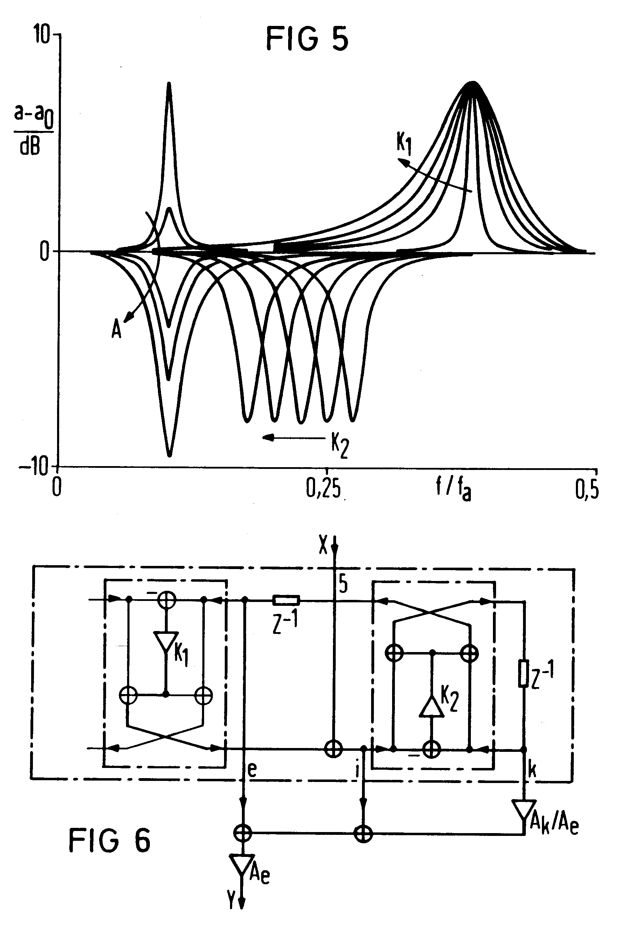

Figur 5 stellt Beispiele eines einstellbaren Dämpfungsentzerrers nach Figur 4 dar. In Abhängigkeit von einer normierten Frequenz f/fₐ ist die Dämpfung (a-a₀) aufgetragen. Durch die eingetragene Pfeilrichtung ist die Wirkung der drei Einstell-Parameter K₁, K₂ und A kenntlich gemacht.

Figur 6 zeigt ein Ausführungsbeispiel für einen sogenannten Auskoppeltyp, d.h. die Einkopplung des Eingangssignals X mit Gewichtung 1 erfolgt nur an einem Schaltungspunkt, nämlich dem Schaltungspunkt 5. Das Ausgangssignal ist wiederum mit Y bezeichnet. Die Schaltung stellt eine kanonische (Teil)-Filterschaltung mit konjugiert komplexem Sperrstellenpaar dar, das strukturbedingt auf dem z-Einheitskreis liegt. Es können Teile des ersten Adaptors entfallen. Das Ausgangssignal Y wird also durch die mit einem ersten Multiplizierer Aₑ gewichtete Summe der an den zwei Schaltungspunkten e und i mit der an einem weiterem Schaltungspunkt k ausgekoppelten und mit einem weiterem Multiplizierer Aₖ/Aₑ gewichteten Signal, gebildet.

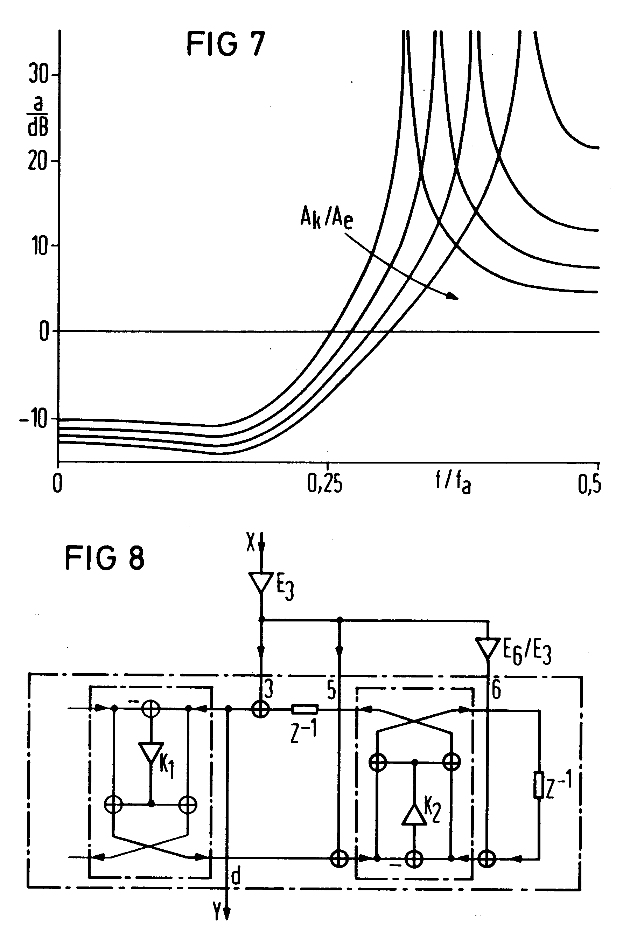

Figur 7 zeigt Beispiele einstellbarer Dämpfungsgänge zur Schaltung nach Figur 6. In Abhängigkeit von einer normierten Frequenz f/fₐ ist die Dämpfung a aufgetragen. Kenntlichgemacht ist durch die eingezeichnete Pfeilrichtung die Wirkung des Multiplizierers Aₖ/Aₑ.

Figur 8 zeigt ein Ausführungsbeispiel eines Einkoppeltyps, d.h. die Auskopplung des Ausgangssignals Y mit Gewichtung 1 erfolgt nur an einem Schaltungspunkt, nämlich dem Schaltungspunkt d. Das Eingangssignal ist wiederum mit X bezeichnet. Die Schaltung stellt eine kanonische (Teil-)Filterschaltung mit konjugiert komplexem Sperrstellenpaar dar, das strukturbedingt auf dem z-Einheitskreis liegt. Teile des ersten Adaptors können entfallen. Das Eingangssignal X wird also nach einer Gewichtung mit einem ersten Multiplizierer E₃ an den zwei Schaltungspunkten 3 und 5 und über eine weitere Gewichtung mit einem zweiten Multiplizierer E₆/E₃ an dem Schaltungspunkt 6 eingekoppelt.

Die dargestellten Schaltungen haben noch folgende Vorteile.

Bei der hier verwendeten rückwirkungsfreien Ein- und Auskopplung bleiben die vorteilhaften Stabilitätseigenschaften der originalen Wellendigitalfilter-Struktur erhalten wenn, wie üblich, weiterhin für die Pseudopassivität [2] der verwendeten Adaptor-Bausteine gesorgt wird.

Die Tatsache, daß die gewünschte Übertragungsfunktion mit der vorgeschlagenen Methode in der Regel sogar auf sehr viele Weisen realisiert werden kann, wird man zweckmäßig bei der Dimensionierung der Schaltung ausnutzen: Durch gezielten Einsatz möglichst vieler Multiplizierer-Werte Null und Eins (also "aufwandlose" Werte) und nur weniger "krumme" Werte (d.h. "echte" Multiplikationen) läßt sich der tatsächliche Aufwand in der Struktur minimieren. So ist passend zur zu realisierenden Übertragungsfunktion immer mindestens eine Dimensionierung möglich, die nur genau die kanonische Mindestzahl "echter" Multiplikationen benötigt.

Problem A (eingangs erwähnt) tritt nicht auf, weil die systematische Verwendung pseudopassiver Adaptoren Schwingungen (mindestens bei Eingangssignall null), unmöglich macht.

Problem B (eingangs erwähnt) entfällt ebenfalls; in der genannten Weise kann eine beliebige Übertragungsfunktion in der Regel sogar mit vielen Multiplizierer-Wertekombinationen erzeugt werden.

Problem C (eingangs erwähnt) tritt nicht auf, weil die Rechentiefe der originalen Wellendigitalfilter-Allpaßstruktur gering ist und durch die Ankopplungen nicht erhöht wird.

### Literaturverzeichnis:

[1] Fettweis, A.: Digital Filter Structures Related to Classical Filter Networks. Arch. elektr. Übertr. 25(1971)2, S. 79-89.
[2] Fettweis, A.: Pseudopassivity, Sensitivity, and Stability of Wave Digital Filters. IEEE Trans. Circuit Theory 19(1972)6, S. 668-673.
[3] Fettweis, A.; Levin, H; Sedlmeyer, A.: Wave Digital Lattice Filters. Int. J. Cir. Theor. Appl. 2(1974)2, S. 203-211.
[4] Fettweis, A.; Meerkötter, K.: Suppression of Parasitic Oscillations in Wave Digital Filters. IEEE Trans. Circuits Syst. 22(1975)3, S. 239-246.
[5] Fettweis. A.: Wave Digital Filters: Theory and Practice. Proc. IEEE 74(1986)2, S. 270-327.

## Patentansprüche

1. Wellendigitalfilter (WDF), bestehend aus Speichern und n-Tor-Adaptoren, die ihrerseits Multiplizierer und Summierer enthalten,
**dadurch gekennzeichnet**,
daß die Übertragungsfunktion (Y/X) beliebig vorgebbar ist in der Weise, daß bei einer in Anzahl (Grad g) und Werten der Nenner-Nullstellen (Eigenwerte) der Übertragungsfunktion (Y/X) übereinstimmenden Wellendigitalfilterstruktur (WDF-Struktur) das Filter-Eingangssignal (X), über Multiplizierer (E₁...Eₓ) individuell gewichtet als Signal X₁ ... Xₓ an allen Adaptor-Ein- und Ausgängen mit Summierern eingekoppelt, und das Filter-Ausgangssignal (Y) durch Summierung der über weitere Multiplizierer (Aₐ ... A_{y}) gewichteten, an allen Adaptor- und Speicher-Ein- und Ausgängen ausgekoppelten Signale Yₐ ... Y_{y} gebildet werden.

2. Wellendigitalfilter nach Anspruch 1,
**dadurch gekennzeichnet**,
daß die Wellendigitalfilterstruktur (WDF-Struktur) eine WDF-Allpaßstruktur, bestehend aus Speichern und 2-Tor-Adaptoren, ist.

3. Wellendigitalfilter nach Anspruch 1 oder 2,
**dadurch gekennzeichnet**,
daß die WDF-Strukturen hinsichtlich Speicherzahl und Multiplizierzahl kanonisch sind, d.h. die Anzahl Speicher entspricht genau der Zahl Eigenwerte der Übertragungsfunktion und die Anzahl Multiplizierer entspricht genau der Zahl freier Parameter in der Übertragungsfunktion.

4. Wellendigitalfilter nach einem der vorhergehenden Ansprüche,
**dadurch gekennzeichnet**,
daß das Eingangssignal (X) mit der Gewichtung 1 an nur einem Punkt der WDF-Struktur direkt eingekoppelt wird.

5. Wellendigitalfilter nach einem der Ansprüche 1 bis 3,
**dadurch gekennzeichnet**,
daß das Ausgangssignal (Y) mit der Gewichtung 1 an nur einem Punkt der WDF-Struktur direkt ausgekoppelt wird.

6. Wellendigitalfilter nach Anspruch 4 bestehend aus einem Wellendigitalfilterallpaß mit zwei Eigenwerten (Grad 2),
**dadurch gekennzeichnet**,
daß das Eingangssignal (X) mit Gewichtung 1 an nur einem Schaltungspunkt (1) als Signal X₁ direkt eingekoppelt wird, und daß das Ausgangssignal (Y) durch Summation der an den zwei Schaltungspunkten (e und h) ausgekoppelten Signale (Yₑ und Yₕ) mit der mit Multiplizierer A gewichteten Differenz der an zwei weiteren Schaltungspunkten (a und c) ausgekoppelten Signale Yₐ und Y_{c} gewonnen wird.

7. Wellendigitalfilter nach Anspruch 4 bestehend aus einem Wellendigitalfilterallpaß mit zwei Eigenwerten (Grad 2),
**dadurch gekennzeichnet**,
daß das Eingangssignal (X) mit Gewichtung 1 an nur einem Schaltungspunkt (5) als Signal X₅ direkt eingekoppelt wird, und daß das Ausgangssignal (Y) durch die mit einem ersten Multiplizierer Aₑ gewichtete Summe der an den zwei Schaltungspunkten (e und i) ausgekoppelten Signale (Yₑ und Yᵢ) mit dem an einem weiteren Schaltungspunkt (k) ausgekoppelten und mit einem weiteren Multiplizierer (Aₖ/Aₑ) gewichteten Signal gebildet wird.

8. Wellendigitalfilter nach Anspruch 5 bestehend aus einem Wellendigitalfilterallpaß mit zwei Eigenwerten (Grad 2),
**dadurch gekennzeichnet**,
daß das Ausgangssignal (Y) mit Gewichtung 1 an nur einem Schaltungspunkt (d) als Signal Y_{d} direkt ausgekoppelt wird, und daß das Eingangssignal (X) nach einer Gewichtung mit einem ersten Multiplizierer (E₃) an den zwei Schaltungspunkten (3 und 5) als Signale X₃ und X₅ und über eine weitere Gewichtung mit einem zweiten Multiplizierer (E₆/E₃) an dem Schaltungspunkt (6) als Signal X₆ eingekoppelt wird.

## Claims

1. Digital wave filter (WDF) comprising memories and n-port adaptors which for their part include multipliers and summers, characterized in that the transfer function (Y/X) can be described arbitrarily in such a way that given a digital wave filter structure (WDF-structure) corresponding in number (factor g) and values to the denominator zero digit positions (eigenvalues) of the transfer function (Y/X) the filter input signal (X) is coupled in, individually weighted as a signal X₁ ... Xₓ, at all the adaptor inputs and outputs by means of summers via multipliers (E₁ ... Eₓ), and the filter output signal (Y) is formed by summing the signals Yₐ ...Y_{y} weighted via further multipliers (Aₐ ... A_{y}) and coupled out at all adaptor and memory inputs and outputs.

2. Digital wave filter according to Claim 1, characterized in that the digital wave filter structure (WDF structure) is a WDF all-pass structure comprising memories and 2-port adaptors.

3. Digital wave filter according to Claim 1 or 2, characterized in that the WDF structures are canonical with respect to number of memories and number of multipliers, that is to say the number of memories corresponds precisely to the number of eigenvalues of the transfer function, and the number of multipliers corresponds precisely to the number of free parameters in the transfer function.

4. Digital wave filter according to one of the preceding claims, characterized in that the input signal (X) having the weighting 1 is directly coupled in at only one point of the WDF structure.

5. Digital wave filter according to one of Claims 1 to 3, characterized in that the output signal (Y) having the weighting 1 is directly coupled out at only one point of the WDF structure.

6. Digital wave filter according to Claim 4, comprising a digital wave filter all-pass circuit having two eigenvalues (degree 2), characterized in that the input signal (X) having weighting 1 is directly coupled in at only one circuit point (1) as signal X₁, and in that the output signal (Y) is obtained by summation of the signals (Yₑ and Yₕ) coupled out at the two circuit points (e and h) with the difference, weighted by means of multipliers A, of the signals Yₐ and Y_{c} coupled out at two further circuit points (a and c).

7. Digital wave filter according to Claim 4, comprising a digital wave filter all-pass circuit having two eigenvalues (degree 2), characterized in that the input signal (X) having weighting 1 is directly coupled in at only one circuit point (5) as signal X₅, and in that the output signal (Y) is formed by means of the sum, weighted by a first multiplier Aₑ, of the signals (Yₑ and Yᵢ), coupled out at the two circuit points (e and i), with the signal coupled out at a further circuit point (k) and weighted by a further multiplier (Aₖ/Aₑ).

8. Digital wave filter according to Claim 5, comprising a digital wave filter all-pass circuit having two eigenvalues (degree 2), characterized in that the output signal (Y) having weighting 1 is directly coupled out at only one circuit point (d) as signal Y_{d}, and in that the input signal (X) is coupled in at the two circuit points (3 and 5) as signals X₃ and X₅ after weighting by a first multiplier (E₃), and is coupled in at the circuit point (6) as signal X₆ by means of a further weighting by a second multiplier (E₆/E₃).

## Revendications

1. Filtre numérique d'ondes (WDF), constitué d'éléments à retard et d'adaptateurs à n portes, qui contiennent pour leur part des multiplicateurs et des additionneurs,
caractérisé par le fait
que la fonction de transfert (Y/X) peut être prédéterminée à volonté de telle sorte que, dans le cas d'une structure du filtre numérique d'ondes (structure WDF), qui correspond au nombre (degré g) et aux valeurs des zéros du dénominateur (valeurs propres) de la fonction de transfert (Y/X), le signal d'entrée (X) du filtre est injecté, par l'intermédiaire de multiplicateurs (E₁...Eₓ), en étant pondéré individuellement en tant que signal X₁...Xₓ à toutes les entrées et sorties d'adaptateurs comportant des additionneurs, et que le signal de sortie (Y) du filtre est formé par addition des signaux Yₐ...Y_{y} pondérés par l'intermédiaire d'autres multiplicateurs (Aₐ...A_{y}) et sortant à toutes les entrées et sorties d'adaptateurs et d'éléments à retard.

2. Filtre numérique d'ondes suivant la revendication 1, caractérisé par le fait que la structure du filtre numérique d'ondes (structure WDF) a une structure de filtre WDF passe-tout, constituée d'éléments à retard et d'adaptateurs biportes.

3. Filtre numérique d'ondes suivant la revendication 1 ou 2, caractérisé par le fait que les structures WDF sont canoniques en ce qui concerne le nombre d'éléments à retard et le nombre de multiplicateurs, c'est-à-dire que le nombre d'éléments à retard correspond exactement au nombre des valeurs propres de la fonction de transfert et que le nombre des multiplicateurs correspond exactement au nombre de paramètres libres dans la fonction de transfert.

4. Filtre numérique d'ondes suivant l'une des revendications précédentes, caractérisé par le fait que le signal d'entrée (X) de pondération 1 n'est injecté directement qu'en un point de la structure WDF.

5. Filtre numérique d'ondes suivant l'une des revendications 1 à 3, caractérisé par le fait que le signal de sortie (Y) de pondération 1 ne sort directement qu'en un point de la structure WDF.

6. Filtre numérique d'ondes suivant la revendication 4, constitué d'un filtre numérique d'ondes passe-tout comportant deux valeurs propres (degré 2), caractérisé par le fait que le signal d'entrée (X) de pondération 1 n'est injecté directement, en tant que signal X₁, qu'en un point (1) du circuit, que le signal de sortie (Y) est obtenu par addition des signaux (Yₑ et Yₕ), sortant aux deux points (e et h) du circuit, et de la différence, pondérée par le multiplicateur (A), des signaux (Yₐ et Y_{c}) sortant en deux autres points (a et c) du circuit.

7. Filtre numérique d'ondes suivant la revendication 4, constitué d'un filtre numérique d'ondes passe-tout comportant deux valeurs propres (degré 2), caractérisé par le fait que le signal d'entrée (X) de pondération 1 n'est injecté directement, en tant que signal X₅, qu'en un point (5) du circuit et que le signal de sortie (Y) est formé par addition, pondérée par un premier multipicateur (Aₑ) des signaux (Yₑ et Yᵢ), qui sortent en deux points (e et i) du circuit, et du signal sortant en un autre point (k) du circuit et pondéré par un autre multiplicateur (Aₖ/Aₑ).

8. Filtre numérique d'ondes suivant la revendication 5, constitué d'un filtre numérique d'ondes passe-tout comportant deux valeurs propres (degré 2), caractérisé par le fait que le signal de sortie (Y) de pondération 1 ne sort directement, en tant que signal Y_{d}, qu'en un point (d) du circuit et que le signal d'entrée (X) est injecté, après une pondération par un premier multiplicateur (E₃), en tant que signaux X₃ et X₅, aux deux points de circuit (3 et 5), et est injecté, par l'intermédiaire d'une autre pondération par un second multiplicateur (E₆/E₃), en tant que signal X₆, au point de circuit (6).
